# EUROPEAN PATENT APPLICATION

(11) **EP 4 040 470 A1**
(43) Date of publication of application: **10.08.2022**
(21) Application number: 21154926.6
(22) Date of filing: 03.02.2021
(51) Int. Cl.: H01L 21/48, H01L 23/495

(54) **A SEMICONDUCTOR DEVICE AND A METHOD OF MANUFACTURING A SEMICONDUCTOR DEVICE**

(71) Applicant: Nexperia B.V., 6534 AB Nijmegen (NL)
(72) Inventor: Lee, Wai Wai, 6534 AB Nijmegen (NL); Suan, Eric Cheam Hing, 6534 AB Nijmegen (NL); Chong, Pek Kee, 6534 AB Nijmegen (NL); Azman, Noorazam Bin, 6534 AB Nijmegen (NL)
(74) Representative: Pjanovic, Ilija

(57) **Abstract**

This disclosure relates to a semiconductor device comprising four flat surfaces on four sides, wherein two sides comprise a full lead end height with electroless plating, and wherein other two sides comprise un-plated exposed Cu tie bar. The full lead end height with electroless plating is an ENIG plating or an ENEPIG plating.

## Description

### FIELD

The present invention relates to a semiconductor device. The invention also relates to a method of manufacturing a semiconductor device.

### BACKGROUND

Leadless packaged semiconductor devices are known to provide advantages over leaded packages. Those advantages include better electrical performance in terms of reduced lead inductance, good heat dissipation by use of an exposed thermal pad to improve heat transfer to a Printed Circuit Board (PCB), reduced package thickness and smaller footprint, which reduces the area occupied on a PCB. Examples of leadless packaged semiconductor devices include Quad-Flat No-lead (QFN) devices and Discrete-Flat No-lead (DFN) devices. However, a disadvantage of leadless packaged semiconductor devices is that inspection of solder joints when mounted on a PCB can be difficult. Conventional inspection techniques utilise so-called Automated Optical Inspection (AOI) systems, whereby a camera scans the leadless packaged semiconductor devices mounted on the PCB for a variety of defects such as open circuit connections, short circuit connections, thinning of the solder connections and incorrectly placed devices. Due to the semiconductor device Input/Output (I/O) terminals being arranged on the bottom of the device, and therefore hidden from view when the device is mounted a PCB, it is not generally possible to use AOI systems with leadless semiconductor devices. Automatic XRay Inspection (AXI) systems may allow inspection of solder joints, however AXI systems are expensive.

A solution allowing solder joints to be inspected by AOI is to include a metal side pads which extend from the device I/O terminals on the bottom of the device at least partially up external sidewall of the device. Typically, the metal side pads may be formed of tin, lead or tin-lead alloys. During soldering processes for attaching the device to the PCB, the solder will wet the l/O terminal on the bottom of the device and also the metal side pads. As a result, a portion of the solder joint will be visible, which allows the inspection by AOI techniques. The solder joint may be considered good, provided that the metal side pads are correctly soldered even if the l/O terminal is not correctly soldered to the PCB.

In addition to ease of inspection, metal side pads may reduce tilting of the device when mounted on a PCB. Metal side pads may also improve shearing and bending performance because of the increased soldered area.

Typically, a package structure will comprise an array of device dies embedded in an encapsulation layer. The device dies will be connected to a lead frame by any appropriate means, such as eutectic bonds. The process of forming a such leadless device involves dividing a two-dimensional array of encapsulated integrated circuits into individual semiconductor device packages using a series of parallel row cuts and parallel column cuts. The first series of parallel singulation cuts extend fully through the lead frame and encapsulation layer defining rows of the array.

After electro-plating metal side pads, a second series of parallel singulation cuts is made extending fully through the lead frame and encapsulation layer. This separates the columns of the array thereby providing singulated packages. In such a process the l/O terminals will be exposed and since the l/O terminals are mutually electrically connected the exposed l/O terminals may be electroplated to form the metal side pads. The electrical connection is necessary to maintain electrical continuity so that the electroplating process can be achieved.

However, for leadless semiconductor devices having two separate functional dies and at least three l/O terminals located at one sidewall of the device and at least two I/O terminals located at an opposing sidewall, it is not possible to form side pads by electroplating according to above process because the singulation cutting sequence requires that middle l/O terminals located at one sidewall of the device formed on a lead frame structure on lead frame will be electrically isolated.

Figure 1 shows a known singulation method for an array of leadless packages, as disclosed in US8809121B2 patent.

Two complete package structures 10 are shown over a tape 12. Each package structure has an array of integrated circuits embedded in an encapsulation layer 14. These circuits connect to a leadframe 16 in conventional manner.

The leadframe 16 has contact pads 18 which are at the bottom surface of each package, for connecting the package to a PCB or other component.

In order to divide individual packaged chips from the 2D array 10, a set of row cuts and column cuts are required. However, plating of the leadframe contacts 18 is required after a cut, so that an exposed cut edge is also plated.

A soldered lead end is desired to ensure that the solder wetting quality is clearly visible from all angles by the naked eye or by optical inspection.

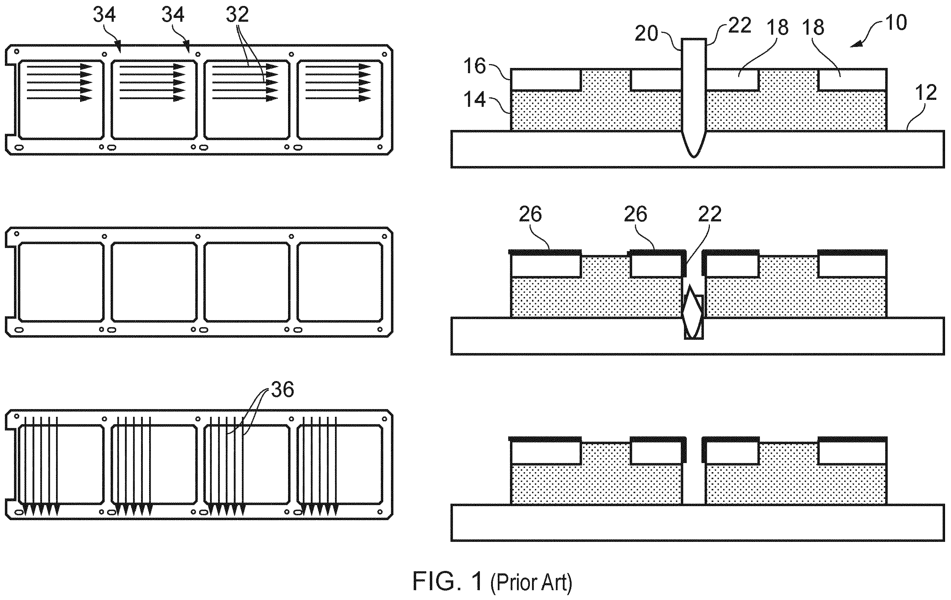

The first step of the known process is to provide a partial cut, using a sawing blade 20, to expose side walls 22 of the leadframe contact pad 18. This is shown in the top part of Figure 1. The partial cut comprises a series of parallel cuts 32 defining a set of rows of packaged ICs, but these have not yet been separated, because the partial cut does not extend fully through the encapsulation layer, as can be seen in the middle cross section in Figure 1.

The middle part of Figure 1 shows a deflashing and plating operation, for example tin plating 26. This plates the base areas of the contact pads 18 as well as the side walls 22.

Two sets of further full depth cuts are needed. A first set 34 completes the partial cuts and a second set 36 is orthogonal to divide the structure 10 into a grid. The first set 28 uses a thinner saw blade to prevent damage to the plated edge area.

The bottom cross section in Figure 1 shows the partial cut being completed. Because the blade is narrower than the first blade, the edge of the package has a stepped edge profile, with the edge of the contact in a recess.

This process requires accurate alignment between the two stages of the cut.

### SUMMARY

Various example embodiments are directed to the disadvantage as described above and/or others which may become apparent from the following disclosure.

According to an embodiment of the present invention a semiconductor device comprises four flat surfaces on four sides, wherein two sides comprise a full lead end height with electroless plating, and wherein other two sides comprise un-plated exposed Cu tie bar.

The semiconductor device comprises SWFs.

The full lead end height with electroless plating is an ENIG plating or an ENEPIG plating.

According to an embodiment of the present invention, a method of producing a semiconductor device comprises steps:
- providing a Cu and Ag spot lead frame,
- attach/bond a die,
- provide wire bonding,
- providing a mold or an encapsulation,
- chopper cut, so to singulate the molded strips from one side,
- provide electroless an ENIG or an ENEPIG plating, and
- provide a full cut, so to fully singulate the strips after plating.

The mold can be an encapsulation molding compound (EMC).

The target thickness of the ENIG or the ENEPIG plating can be: Ni around 2um, Pd around 0.3um, and Au around 0.05um.

The step of the full cut can be executed with a thinner blade, so to provide a SWF at four sides of the semiconductor device with a step.

According to an embodiment of the present invention, the step of providing an electroless ENIG or ENEPIG plating, comprises steps:
- electro cleaning,
- providing an activator,
- providing an electroless nickel plating,
- providing an electroless palladium plating, wherein this step is required only for ENEPIG,
- gold immersion, and
- providing a post treatment.

The semiconductor device according to the above described embodiments enables SWF on a leadless package for thin lead frames, e.g. in range around 100um, with full wettable lead end height and flat package surface for 4 sides. Same plating finishing for lead-side and lead-bottom is applied, so that the semiconductor device is fully satisfying the demanding automotive industry requirements.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 shows a known singulation method for an array of leadless packages;
Figure 2 illustrates a semiconductor device according to an embodiment of the invention;
Figure 3 illustrates a method of manufacturing a semiconductor device according to an embodiment of the invention;
Figure 4 illustrates a method of manufacturing a semiconductor device according to an embodiment of the invention, details of step of providing an electroless ENIG or ENEPIG plating;
Figure 5 illustrates a method of manufacturing a semiconductor device according to an embodiment of the invention;
Figure 6 illustrates a method of manufacturing a semiconductor device according to an embodiment of the invention.

### DETAILED DESCRIPTION

According to an embodiment of the present invention, a side wettable flank (SWF) is created on multiple I/O, more than 6 pins, leadless packages. The SWF can be created through a chopper cut and an electroless plating with electroless nickel immersion gold (ENIG) or electroless nickel electroless palladium immersion gold (ENEPIG). In this way it is enabled to have a SWF on leadless package for thin lead frames, e.g. 100um lead frames, with full wettable lead end height and flat package surface for four sides. The same plating finishing can be used for a lead-side and a lead-bottom, which is especially important for the high end requirements in automotive industry.

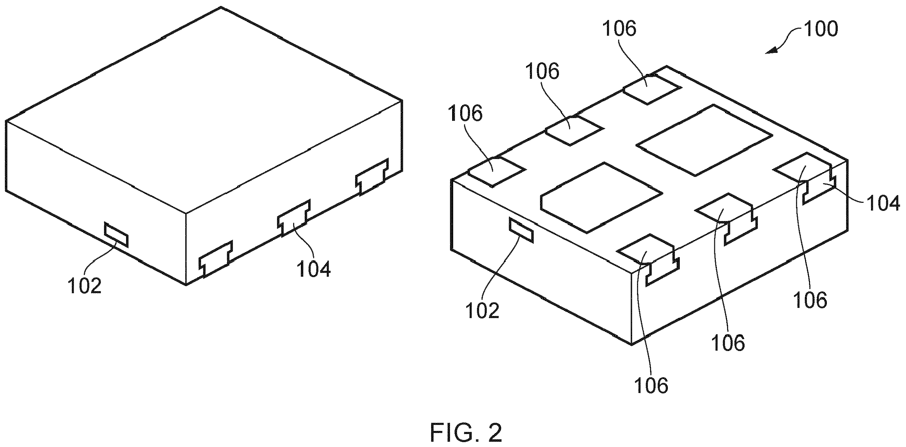

An embodiment of the present invention is shown in Figure 2. A semiconductor device package 100 comprises six SWF 106, four flat surfaces on four sides, full lead end height with electroless, e.g. ENIG or ENEPIG, plating 104 on two sides and un-plated exposed Cu tie bar 102 on another two sides. Such a semiconductor package 100 can be used for more than six l/O since there is no limitations on the lead frame trace connections.

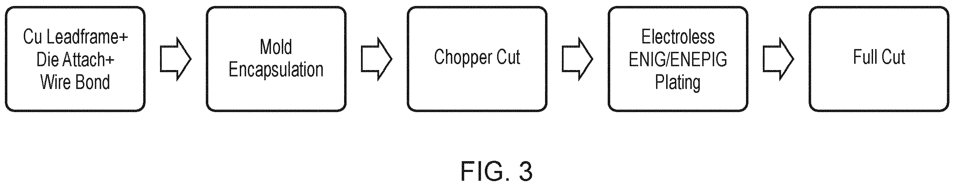

According to an embodiment of the present invention, as shown in Figure 3, a method of manufacturing a semiconductor package with SWF with ENIG or ENEPIG plating, comprises the steps:
- providing a Cu and Ag spot lead frame, attach/bond a die, provide wire bonding;
- providing a mold or an encapsulation; the mold can be encapsulation molding compound (EMC);
- chopper cut, so to singulate the molded strips from one side;
- provide electroless ENIG or ENEPIG plating; the strips are plated with ENIG/ENEPIG, wherein the target thickness can be: Ni 2um, Pd 0.3um, Au 0.05um;
- provide a full cut, so to fully singulate the strips after plating.

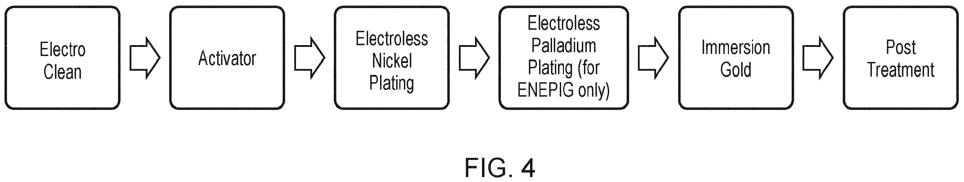

According to an embodiment of the present invention, as shown in Figure 4, a step of providing an electroless ENIG or ENEPIG plating, comprises steps:
- electro cleaning
- providing an activator
- providing an electroless nickel plating
- providing an electroless palladium plating, wherein this step is required only for ENEPIG
- gold immersion
- providing a post treatment.

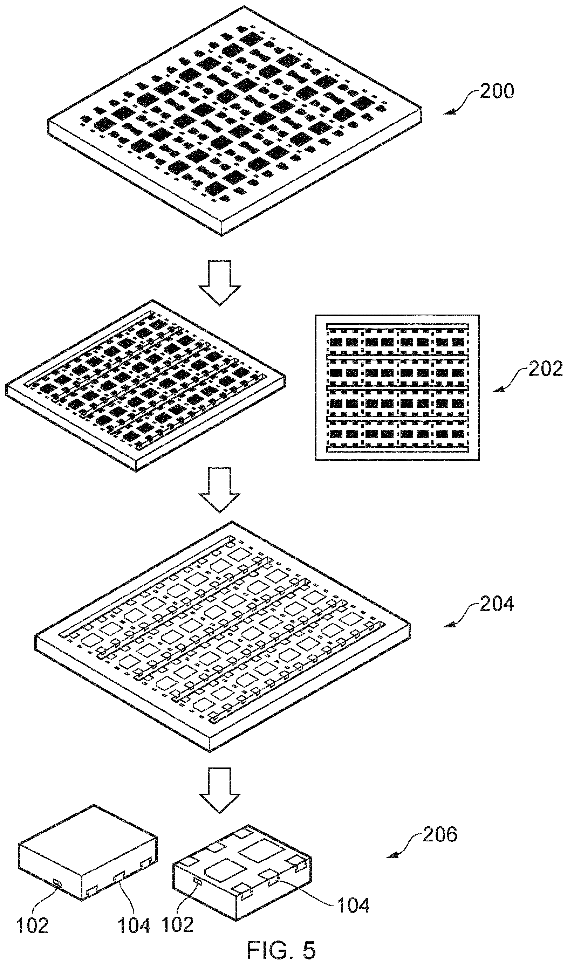

According to an embodiment of the present invention, as shown in in Figure 5, a method of manufacturing a semiconductor package comprises steps:
- reference sign 200 in Figure 5:
   ∘ mold encapsulation, wherein a bottom view of a mold body is shown
- reference sign 202 in Figure 5:
   ∘ a chopper cut, a through cut for a single site only, exposed side lead for plating process
- reference sign 204 in Figure 5:
   ∘ an electroless ENIG or ENEPIG plating
- reference sign 206 in Figure 5:
   ∘ final cut.

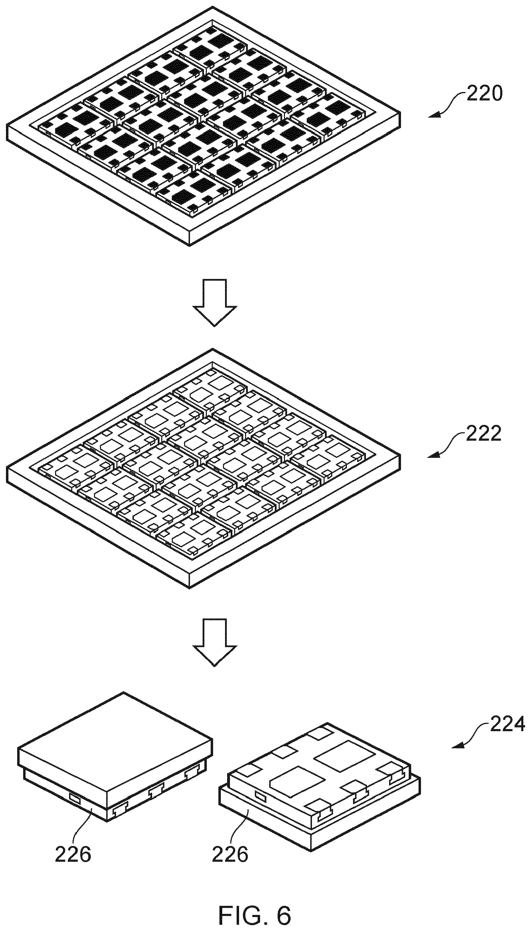

According to an embodiment of the present invention, as shown in in Figure 6, a method of manufacturing a semiconductor package comprises steps:
- reference sign 220 in Figure 6:
   ∘ a chopper cut partially into EMC on all 4 sides
- reference sign 222 in Figure 6:
   ∘ an electroless ENIG or ENEPIG plating
- reference sign 224 in Figure 6:
   ∘ final cut with a thinner blade, which provides a SWF at four sides with a step 226 in a package outline.

A semiconductor package according to above described embodiments, is especially suitable for a DFN package with SWF, with a thin lead frame based package and enabling full compliance to automotive AOI requirement.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A semiconductor device comprising four flat surfaces on four sides, wherein two sides comprise a full lead end height with electroless plating, and wherein other two sides comprise un-plated exposed Cu tie bar.

2. A semiconductor device as claimed in claim 1, wherein semiconductor device comprises SWFs.

3. A semiconductor device as claimed in any of the previous claims, wherein the full lead end height with electroless plating is an ENIG plating or an ENEPIG plating.

4. A method of producing a semiconductor device, the method comprising steps:
- providing a Cu and Ag spot lead frame,
- attach/bond a die,
- provide wire bonding,
- providing a mold or an encapsulation,
- chopper cut, so to singulate the molded strips from one side,
- provide electroless an ENIG or an ENEPIG plating, and
- provide a full cut, so to fully singulate the strips after plating.

5. A method of producing a semiconductor device as claimed in claim 4, wherein the mold is an encapsulation molding compound (EMC).

6. A method of producing a semiconductor device as claimed in claims 4 or 5, wherein the target thickness of the ENIG or the ENEPIG plating is: Ni around 2um, Pd around 0.3um, and Au around 0.05um.

7. A method of producing a semiconductor device as claimed in claims 4 to 6, wherein the step of the full cut is executed with a thinner blade, so to provide a SWF at four sides of the semiconductor device with a step.

8. A method of producing a semiconductor device as claimed in claims 4 to 7, wherein the step of providing an electroless ENIG or ENEPIG plating, comprises steps:
- electro cleaning,
- providing an activator,
- providing an electroless nickel plating,
- providing an electroless palladium plating, wherein this step is required only for ENEPIG,
- gold immersion, and
- providing a post treatment.
